# EUROPEAN PATENT SPECIFICATION

(11) **EP 3 089 206 B1**
(45) Date of publication and mention of the grant of the patent: **17.04.2019**
(21) Application number: 14873664.8
(22) Date of filing: 20.11.2014
(51) Int. Cl.: H01L 21/822, H01L 27/04, H01L 27/02, G06F 17/50, H01L 21/66

(54) **SEMICONDUCTOR DEVICE, AND DESIGN METHOD FOR SAME**
HALBLEITERBAUELEMENT UND ENTWURFSVERFAHREN DAFÜR
DISPOSITIF À SEMI-CONDUCTEURS ET SON PROCÉDÉ DE CONCEPTION

(30) Priority: 26.12.2013 JP 2013269647
(43) Date of publication of application: 02.11.2016
(73) Proprietor: Rohm Co., Ltd., Kyoto-shi, Kyoto 615-8585 (JP)
(72) Inventor: IWATA, Kotaro, Kyoto-Shi Kyoto 615-8585 (JP); TANAKA, Kunimasa, Kyoto-Shi Kyoto 615-8585 (JP)
(74) Representative: Isarpatent
(86) International application number: PCT/JP2014/080706
(87) International publication number: WO 2015/098379

(56) References cited:
- EP-A2- 0 224 274
- JP-A- H08 213 441
- JP-A- S62 229 866
- JP-A- S63 229 757
- JP-A- S63 229 758
- JP-A- 2001 015 655
- JP-A- 2006 332 176
- JP-A- 2006 344 721
- JP-A- 2008 172 132
- JP-A- 2011 049 272
- JP-A- 2011 049 273
- JP-A- 2011 108 751
- JP-A- 2013 004 677
- US-A- 5 869 878
- US-A1- 2010 001 785

## Description

### Technical Field

The present invention relates to semiconductor devices and to methods for designing them, and more particularly to those provided with a heat source element and a temperature sensing element.

### Background Art

In a semiconductor device, a heat source element is typically, for example, a bipolar or MIS power transistor through which an electric current of several hundred milliamperes to several amperes passes. A temperature sensing element denotes a semiconductor element that detects the temperature of a semiconductor chip in which a power transistor is formed, in particular the junction temperature of the power transistor itself, and can be an active device, such as a transistor, or a passive device, such as a diode or a resistor.

A heat source element and a temperature sensing element are adopted in, for example, voltage regulators and DC/DC converters. A high current passes, in a bipolar type, between the collector and emitter of the transistor and, in a MIS type, between the source and drain. Moreover, when a high voltage is applied between the two electrodes, those power transistors consume large amounts of electric power. For example, when a current of 200 mA passes between the source and drain of a MIS transistor, and a voltage of 8 V is applied between the two electrodes, the MIS transistor consumes electric power of 1.6 W.

As electric power consumption increases, the junction temperature of a power transistor rises, and accordingly the junction temperature of those semiconductor elements which are formed nearby rises. With an abnormally high junction temperature, a semiconductor device is exposed to the risk of deterioration or destruction. To overcome the inconvenience, a temperature sensing element is arranged in a semiconductor chip, particularly near a power transistor, to detect the temperature of the semiconductor chip so that, when a predetermined temperature is reached, the operation of the power transistor and other semiconductor elements, or of the entire semiconductor device, is shut off, thereby to prevent deterioration or destruction of the semiconductor device.

Patent Document 1 discloses a method for manufacturing a semiconductor integrated circuit device as well as a semiconductor integrated circuit device. A temperature detection circuit portion is provided that detects the temperature of a power MIS transistor in operation and that, when the temperature equals a predetermined value or more, stops the operation of the power MIS transistor. At the center of a power MOSFET region, a temperature detection circuit region is arranged. Purportedly, arranging the temperature detection circuit region at the center of the power MOSFET region, which has the highest temperature when a power IC is in operation, helps enhance temperature detection sensitivity so that power IC protection operation can be performed reliably at a proper time.

Patent Document 2 discloses a temperature detection circuit and an overheat protection circuit. A diode with temperature dependence is provided in the temperature detection circuit, and an output transistor is arranged so as to surround the diode. Purportedly, the diode with temperature dependence is preferably arranged near the output transistor from the viewpoints of both efficiency and precision, and thus the diode is arranged in a central part of the output transistor (see Patent Document 2, Fig. 5).

Patent Document 3 discloses a semiconductor device protected against overheating having a heat-sensitive element formed on insulation film to detect the temperature of the substrate. The semiconductor substrate has a power region and a control region. A VMOS transistor, i.e. an active semiconductor element, is formed on the power region. An insulation film is formed on part of the control region. A polycrystalline silicon diode, which functions as a heat-sensitive element, is formed on the insulation film. A control section, comprising a lateral type, MOS transistor, is formed on the control region. The MOS transistor is connected to receive a signal from the diode. A polycrystalline silicon resistor, determining a circuit constant, is formed on the insulation film. The MOS transistor is protected by the active semiconductor element in response to a signal supplied from the heat-sensitive element.

### List of Citations

### Patent Literature

Patent Document 1: Japanese Patent Application Publication No. H11-177087
Patent Document 2: Japanese Patent Application Publication No. 2002-108465
Patent Document 3: EP224274-A2.

### Summary of the Invention

### Technical Problem

Patent Documents 1-3 are similar in that a heat source element and a temperature sensing element are provided and that the temperature sensing element is arranged near the heat source element. They also share the reason for arranging the two elements next to each other: to enhance the temperature detection sensitivity of the heat source element (power transistor).

Nowadays, semiconductor devices themselves are increasingly miniaturized, and accordingly heat source elements are increasingly miniaturized and made increasingly compact. As the area and volume of a heat source decrease, the proportion of a heat source element in a semiconductor chip decreases, and heat generation density increases, making a heat gradient in the semiconductor chip more notable. Against this background, the present inventors studied how best the heat source element and the temperature sensing element disclosed in Patent Documents 1 and 2 could be arranged. As a result, it has been found that, even when semiconductor elements are arranged near each other, simply arranging the two elements close to each other as suggested in Patent Documents 1 and 2 does not achieve sufficient thermal protection. Based on this finding, the present invention aims to provide a semiconductor device, and a method for designing one, that helps enhance the temperature detection precision of a temperature sensing element and that allows efficient arrangement of a thermal protection circuit including the temperature sensing element in a semiconductor chip.

### Means for Solving the Problem

According to one aspect of the present invention, a semiconductor device includes a heat source element and a temperature sensing element. As seen in a plan view, the heat source element has a shape defined by: a first side (11); a second side (12) that is located on the same line as, but a second distance x3 away from, the first side (11) and that extends over a third distance x2 in a direction away from the first side (11); a third side (13) that has the same length as the second distance x3; a fourth side (14) that connects together one end of the first side (11) and one end of the third side (13); a fifth side (15) that connects together one end of the second side (12) and the other end of the third side (13); a sixth side (16) of which one end is connected to the other end of the first side (11) and that extends in the same direction as, and has a larger length than, the fourth side (14), the length being expressed as a length y0; a seventh side (17) that is connected to the other end of the second side (12) and of which one end extends in the same direction as, and has a larger length than, the fifth side (15), the length being expressed as the length y0; and an eighth side (18) that connects together the other end of the sixth side (16) and the other end of the seventh side (17). The eighth side (18) has a length x0, and the temperature sensing element is arranged near the third side (13). A central portion of the temperature sensing element is arranged nearer to the third side than to the fourth and fifth sides.

According to another aspect of the present invention, a semiconductor device has a heat source element and a temperature sensing element in a semiconductor chip. The heat source element has a U-shape composed of two opposing regions that are located on opposite sides of a space portion and a coupling region that couples together the two opposing regions. The temperature sensing element is arranged in the space portion near the coupling region. A distance between a central portion of the temperature sensing element and a central portion of the coupling region is shorter than a distance between the central portion of the temperature sensing element and a central portion of one of the opposing regions.

According to yet another aspect of the present invention, a method for designing a semiconductor device includes: a first step of dividing a U-shaped heat source element having a space portion into three regions and determining the sizes and shapes of the divided regions and of the space portion; a second step of performing a heat distribution simulation with respect to the heat source element and the space portion determined in the first step; a third step of analyzing simulation results performed in the second step; and a fourth step of determining the sizes of the three regions and of the space portion based on simulation results obtained in the third step.

### Advantageous Effects of the Invention

A U-shaped heat source element provided in a semiconductor device according to the present invention is set to have a size of a predetermined shape based on a heat distribution simulation. In addition, a space portion having a predetermined shape and size is demarcated, and in the space portion, a temperature sensing element can be arranged efficiently, with enhanced temperature detection sensitivity and precision.

### Brief Description of Drawings

[Fig. 1] is a schematic diagram of a semiconductor device according to the present invention;
[Fig. 2] is an arrangement diagram of the heat source element and the temperature sensing element shown in Fig. 1; [Fig. 3] is a modified diagram of Fig. 2;[Fig. 4] is another modified diagram of Fig. 2;
[Fig. 5A], [Fig. 5B], and [Fig. 5C] are [[a]] heat distribution simulation diagrams of a semiconductor device according to the present invention;
[Fig. 6A], [Fig. 6B], and [Fig. 6C] are another heat distribution simulation diagrams of a semiconductor device according to the present invention;
[Fig. 7] is a temperature gradient diagram of the heat distribution simulation shown in Fig. 5;
[Fig. 8] is a temperature gradient diagram of the heat distribution simulation shown in Fig. 6;
[Fig. 9] is a temperature gradient diagram of the temperature, as determined through simulations, at the central portion Tc of a temperature sensing element TE according to the present invention;
[Fig. 10] is a simulation diagram showing a relationship between consumed electric power and temperature detection sensitivity in a heat source element HSE according to the present invention;
[Fig. 11] is a diagram showing an area ratio between a heat source element HSE and a space portion according to the present invention; and
[Fig. 12] is a diagram showing one example of a specific circuit of a thermal protection circuit TSD arranged in a space portion according to the present invention.

### Description of Embodiments

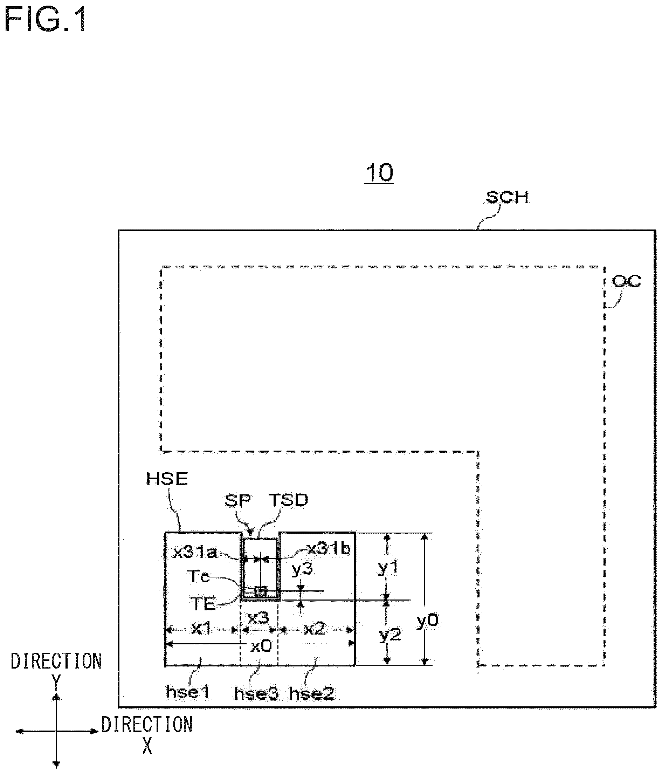

Fig. 1 is a schematic diagram of a semiconductor device according to the present invention. The semiconductor device 10 has a heat source element HSE and a temperature sensing element TE formed in a semiconductor chip SCH having a silicon substrate. In the present invention, the heat source element HSE can be a bipolar transistor, a MIS transistor, or the like that acts as a source of heat, like an output transistor or a power transistor used in a voltage regulator, a DC/DC converter, or the like. On the other hand, the temperature sensing element TE can be a semiconductor element, in particular a transistor, a diode, a resistor, or the like, that functions as a temperature sensor provided to monitor the temperature of a heat source element HSE.

As seen in a plan view, the heat source element HSE is formed in a U shape. The heat source element HSE is composed of opposing regions hse1 and hse2 with a comparatively large area and a coupling region hse3 with a comparatively small area. The opposing regions hse1 and hse2 have approximately equal areas. The area of the opposing region hse1 is expressed as the product of its lengths x1 and y0 in directions X and Y respectively. The area of the opposing region hse2 is expressed as the product of its lengths x2 and y0 in directions X and Y respectively. Making lengths x1 and x2 equal gives the opposing regions hse1 and hse2 equal areas. The two are usually designed to have equal areas. However, the two can be given different areas depending on how various semiconductor elements and bonding pads are located around the heat source element HSE and how semiconductor elements are wired with each other.

The area of the coupling region hse3 is expressed as the product of its lengths x3 and y2 in directions X and Y respectively. The coupling region hse3 is located between the opposing regions hse1 and hse2 so as to couple together the opposing regions hse1 and hse2. Providing the coupling region hse3 between the opposing regions hse1 and hse2 leaves a space portion SP, where a thermal protection circuit TSD is arranged. The temperature sensing element TE, which functions as a temperature sensor, is a part of the thermal protection circuit TSD. The distance y3 from a central portion Tc of the temperature sensing element TE to one side of the coupling region hse3 is designed to be shorter than the shortest distances x31a and x31b from the central portion Tc of the temperature sensing element TE to the opposing regions hse1 and hse2. The reason is as follows: heat conducts to the entire temperature sensing element TE from three directions, namely from the opposing region hse1, from the opposing region hse2, and from the coupling region hse3; with no heat source element HSE present on the side opposite from the coupling region hse3, heat conduction is weaker in direction Y than in direction X. Accordingly, to strengthen heat conduction from the coupling region hse3, the distance between one side of the coupling region hse3 and the central portion Tc of the temperature sensing element TE is reduced. More preferably, the distance from a central portion of the coupling region hse3 to the central portion Tc of the temperature sensing element TE is made shorter than the distance from central portions of the opposing regions hse1 and hse2 to the central portion Tc of the temperature sensing element TE. The aim is as follows: it is surmised that the coupling region hse3 and the opposing regions hse1 and hse2 has highest temperatures at their respective central portions; reducing the distance from the central portion of the coupling region hse3 to the central portion Tc of the temperature sensing element TE helps increase and quicken heat conduction from the coupling region hse3 to the temperature sensing element TE.

Assuming that the length y0 of the heat source element HSE in direction Y is constant, the area of the coupling region hse3 is inversely proportional to that of the space portion SP. That is, increasing length y1 results in reducing length y2, and, conversely, increasing length y2 results in reducing length y1. In the present invention, length y1, which relates to the space portion SP, is determined with priority over length y2, which is related to the coupling region hse3. The aim is to secure a sufficiently large space portion SP to arrange the thermal protection circuit TSD in. Determining length y1 with priority given to the size of the space portion SP affects the area of the coupling region hse3. On the other hand, however, the coupling region hse3 is required to be so large as to conduct sufficient heat to the temperature sensing element TE, and thus needs to have a predetermined or larger area. Thus, there is a limit to giving length y1 priority.

The space portion SP also needs to have a predetermined entrance width, that is, a predetermined length x3, to arrange the thermal protection circuit TSD in. In addition, the space portion SP needs to have a depth, that is, a length y1, sufficiently large not only to secure a sufficient length and area to arrange the thermal protection circuit TSD in but also to allow sufficient heat conduction from the heat source element HSE to the temperature sensing element TE. According to various heat distribution simulations conducted with the present invention, it has been found out that it is preferable that lengths y0 and y1 have the relationship 0.25 ≤ y1 / y0 ≤ 0.75. Accordingly, setting such that y1 / y0 = 0.25 results in making y2 / y0 = 0.75, and setting such that y1 / y0 = 0.75 results in making y2 / y0 = 0.25. How these values are derived will be discussed later. Lengths y0, y1, and y2 are specifically such that, for example, y0 = 350 µm and y1 = y2 = 175µm, and these lengths are determined on the basis of the current, power, etc. tolerated in the heat source element HSE.

The lengths of the heat source element HSE and the space portion SP in direction X, namely lengths x1, x2, and x3 are determined basically on largely the same basis as lengths y1 and y2. Specifically, lengths x1, x2, and x3 are determined on the basis of the current, power, etc. tolerated in the heat source element HSE. For example, they are set such that x1 = x2 = 250 µm and x3 = 140 µm. Incidentally, lengths x1 and x2 are often determined on the basis of the current and power required in the heat source element HSE rather than from the perspective of securing the space portion to accommodate the thermal protection circuit TSD in.

According to various heat distribution simulations conducted with the present invention, it has been found out that it is preferable that lengths x0, x1, x2, and x3 have the relationship x3 ≤ x1 = x2 ≤ 3 × x3. Accordingly, for example, setting such that x3 = 140 µm results in making 140 µm ≤ x1 = x2 ≤ 420 µm.

In addition to the heat source element HSE and the thermal protection circuit TSD, another circuit OC is formed in the semiconductor chip SCH. For example, in a case where the semiconductor device 10 includes an LDO (low dropout) regulator, the other circuit OC includes a reference voltage source, a driver for driving an output transistor (heat source element HSE), various control circuits, etc.

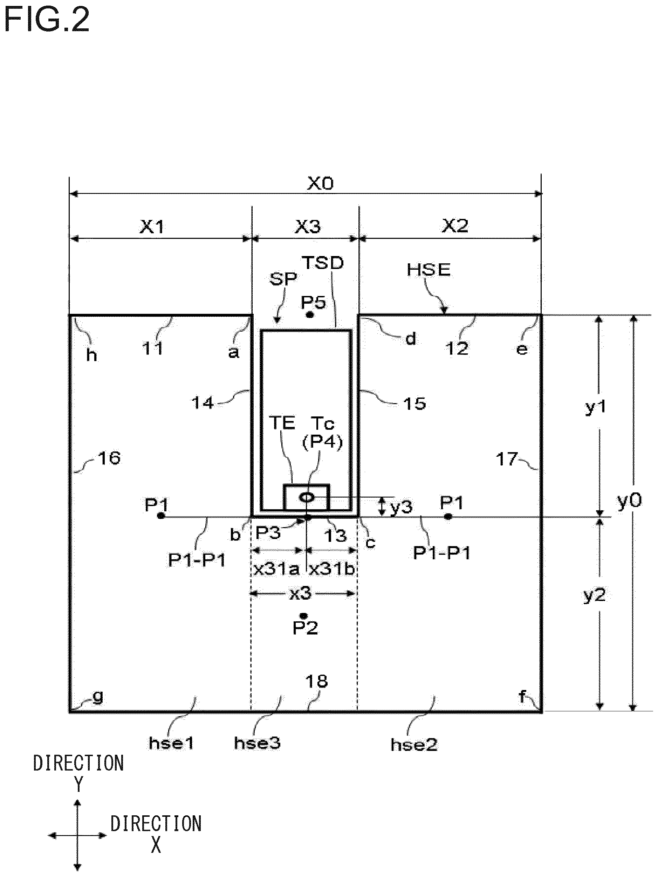

Fig. 2 shows an arrangement of the heat source element HSE and the temperature sensing element TE shown in Fig. 1, and particularly shows a positional relationship of the heat source element HSE and the thermal protection circuit TSD including the temperature sensing element TE relative to each other on an enlarged scale. For a detailed discussion of their positional relationship, Fig. 2 includes more reference signs than Fig. 1. The following description proceeds with reference to Fig. 2, by use of those reference signs.

In Fig. 2, the heat source element HSE has a U shape. The U shape of the heat source element HSE is composed of a first side 11, a second side 12, a third side 13, a fourth side 14, a fifth side 15, a sixth side 16, a seventh side 17, and an eighth side 18. The first and second sides 11 and 12 are located on the same line, a length x3 apart from each other, and have approximately equal lengths x1 and length x2. The second side 12 extends in a direction away from the direction in which the first side 11 extends. The third side 13 is located a length y1 away from the first and second sides 11 and 12 in a direction perpendicular to these, and has a length approximately equal to length x3. The fourth side 14 extends from end a to end b, and has a length approximately equal to length y1. The fifth side 15 extends from end c an end d, and has a length approximately equal to length y1. The sixth side 16 is parallel to, but longer than, the fourth side 14; it extends from end g to end h, and has a length y0. The seventh side 17 is parallel to, but longer than, the fifth side 15; it extends from end e to end f, and has a length y0. The eighth side 18 is substantially parallel to the first, second, and third sides 11, 12, and 13; it extends from end f to end g, and has a length x0. Length x0 equals the sum of the lengths x1, x2, and x3.

For convenience' sake in terms of description and in particular that of heat distribution simulations described later, the heat source element HSE is divided into three parts, namely the opposing regions hse1 and hse2 and the coupling region hse3. In the specific embodiment shown in Fig. 2, division is achieved by extending the fourth and fifth sides 14 and 15 so as to form two opposing regions and one coupling region; instead, division may be achieved by extending the third side 13 in direction X. Also in that configuration, the heat source element HSE is composed of two opposing regions located at opposite sides of a space portion SP and one coupling region coupling together the two opposing regions.

In Fig. 2, points P1, which indicate the central portions of the opposing regions hse1 and hse2, are surmised to be the spots where the heat source element HSE has the highest temperature. The central portion of the coupling region hse3 is indicated by point P2, which too is surmised to be at approximately as high a temperature as at points P1 provided that coupling region hse3 has a predetermined or larger size. A central portion of one side of the coupling region hse3, namely the third side 13, is indicated by point P3. Point P3 is the spot on the heat source element HSE which is closest to the central portion Tc of the temperature sensing element. Point P4 is identical with the central portion Tc of the temperature sensing element TE. The temperature detected at point P4 is extremely important in estimating the temperature of the heat source element HSE. Point P5 is located at the entrance of the space portion SP, and is surmised to be the spot at which the space portion SP has the lowest temperature. Accordingly, detecting the temperature at point P5 is extremely useful in grasping the heat distribution and heat gradient over the enter thermal protection circuit TSD.

The size and shape of the space portion SP are defined by the opposing regions hse1 and hse2 and the coupling region hse3. The entrance width of the space portion SP equals length x3, and the depth of the space portion SP equals length y1. In the space portion SP, the thermal protection circuit TSD is arranged. In particular, the shortest distance y3 between the central portion Tc of the temperature sensing element TE and the third side 13 is set shorter than the shortest distance x31a between the central portion Tc (point P4) and the fourth side 14 and shorter than the shortest distance x31b between the central portion Tc and the fifth side 15. The distance from point P2, which is the central portion of the coupling region hse3, and the central portion Tc (point P4) is set shorter than the distance between point P1, which is the central portion of the opposing region hse1, and the central portion Tc (point P4). On the opposite side of the temperature sensing element TE from the coupling region hse3, no semiconductor device that acts as a heat source is present; thus, heat conduction is weaker in direction Y than in direction X. This inconvenience can be alleviated by the configuration described above.

In the configuration shown in Fig. 2, the space portion SP and the coupling region hse3 are substantially the same size. Specifically, lengths y0, y1, and y2 are such that the ratio y1 / y0 equals 0.5, the ratio y2 / y0 equals 0.5, and lengths y1 and y2 are equal. The entrance width of the space portion SP, that is, length x3, equals approximately one-half of length x1 or x2. In this configuration, the coupling region hse3 occupies one-eighths (12.5%) of the area of the opposing regions hse1 and hse2. The ratio of the area of the space portion SP to the area of the heat source element HSE equals approximately one-ninth (11.1%).

Moreover, in the configuration shown in Fig. 2, the third side 13 is located on line segment P1-P1 that connects between points P1, that is, the central portions of the opposing regions hse1 and hse2, so that the temperature sensing element TE is located slightly away from line segment P1-P1. However, the ratio y1 / y0 = 0.5 may be set slightly higher, for example at 0.55, so that the temperature sensing element TE is arranged on line segment P1-P1.

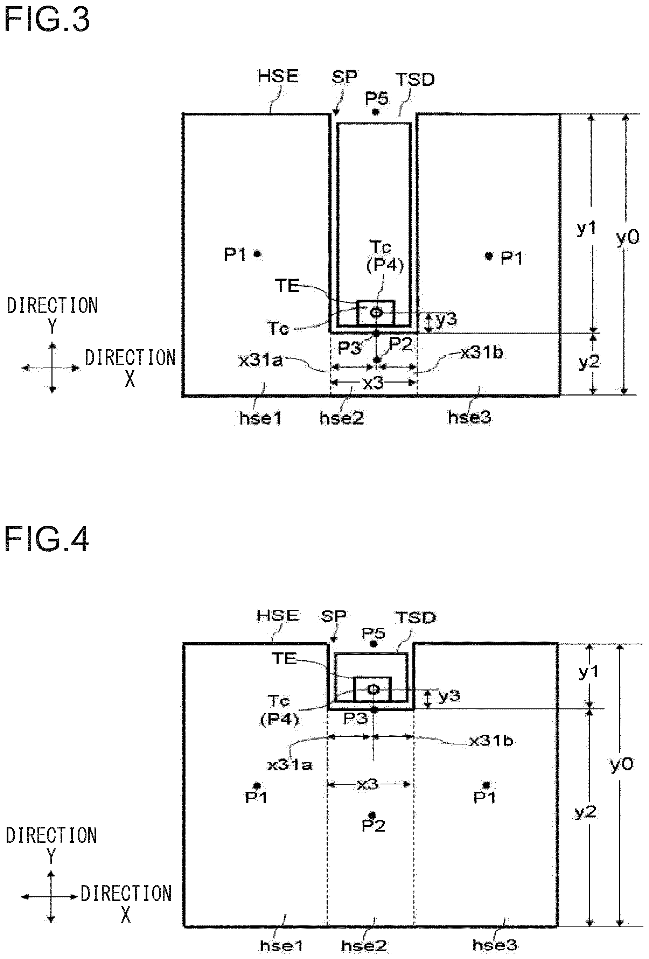

Fig. 3 shows one modified example of Fig. 2. Fig. 3 differs from Fig. 2 in the depth of the space portion SP; specifically, the proportion of length y1 in length y0 is higher. Fig. 3 schematically shows a configuration where the ratio of y1 to y0, that is, y1 / y0, is set at 0.75. Increasing the ratio y1 / y0 results in increasing the area of the space portion SP; on the other hand, the coupling region hse3 then has a smaller area. As the thermal protection circuit TSD has an increasingly large circuit scale, it occupies an increasingly large part of the area of the space portion SP. However, as the coupling region hse3 is increasingly small, the amount of heat that conducts from the coupling region hse3 to the temperature sensing element TE is increasingly small; it is surmised that, simultaneously, the temperature difference between points P1, which are the central portions of the opposing regions hse1 and hse2, and point P2, which is the central portion of the coupling region hse3, is increasingly large. Accordingly, reducing the area of the coupling region hse3 results in lowering the temperature detection sensitivity of the temperature sensing element TE, and this cannot be said preferable.

Irrespective of the area of the space portion SP, the shortest distance y3 between the central portion Tc (point P4) of the temperature sensing element TE and the coupling region hse3 is set shorter than the shortest distances x31a and x1b between the central portion Tc and the opposing regions hse1 and hse2. The distance between the central portion Tc and point P2 is set shorter than the distance between the central portion Tc and point P1. In this way, it is possible to correct for the difference in heat conduction between across the coupling region hse3 and across the opposing regions hse1 and hse2.

Setting the ratio y1 / y0 of length y1 to length y0 at 0.75 gives the space portion SP a large depth, but gives the coupling region hse3 a reduced area due to the ratio y2 / y0 of length y2 to length y0 being 0.25.

Fig. 4 shows another modified example of Fig. 2. Fig. 4 differs from Figs. 2 and 3 in the depth of the space portion SP; specifically the proportion of length y1 in length y0 is lower. Fig. 4 schematically shows a configuration where the ratio y1 / y0 of y1 to y0 is set at 0.25. Reducing the ratio y1 / y0 results in reducing the area of the space portion SP; on the other hand, the heat source element HSE then has a larger area. As the thermal protection circuit TSD has an increasingly small circuit scale, an increasingly small area is required in the space portion SP. However, too small an area of the space portion SP makes it impossible to arrange the thermal protection circuit TSD amply in the space portion SP. It is generally surmised that enlarging the coupling region hse3 will pose no problem from the perspective of heat conduction. On the other hand, the distance from point P2, which is the central portion of the coupling region hse3, to the central portion (point P4) of the temperature sensing element TE will then be larger, and thus it is also surmised that the efficiency of heat conduction from the coupling region hse3 will be lower.

Also in Fig. 4, irrespective of the area of the space portion SP, the shortest distance y3 between the central portion Tc (point P4) of the temperature sensing element TE and the coupling region hse3 is set shorter than the shortest distances x31a and x31b between the central portion Tc and the opposing regions hse1 and hse2. The distance between the central portion Tc and point P2 is set shorter than the distance between the central portion Tc and point P1. In this way, it is possible to suppress a difference in heat conduction between across the coupling region hse3 and across opposing regions hse1 and hse2.

Setting the ratio y1 / y0 of y1 to y0 at 0.25 gives the space portion SP a small depth, but gives the coupling region hse3 an increased area due to the ratio y2 / y0 of y2 to / y0 being 0.75.

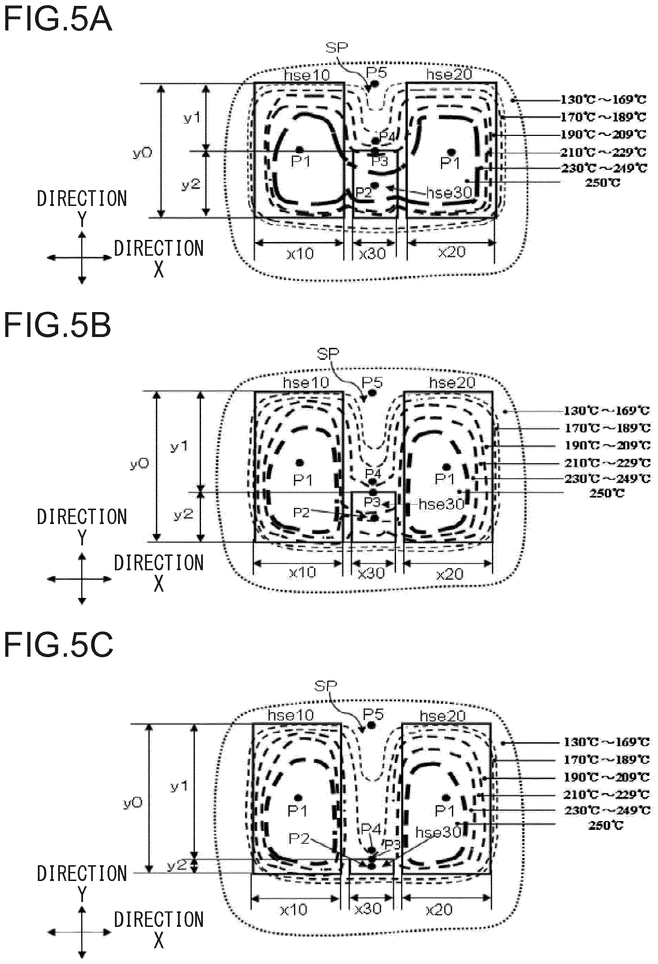

Figs. 5A to 5C show the results of heat distribution simulations with the U-shaped heat source element HSE and the space portion SP shown in Figs. 1 to 4. The simulations were performed with the U-shaped heat source element HSE divided into three parts; it was divided, as shown in Figs. 1 and 2, along direction X into three parts, namely two opposing regions hse10 and hse20 and one coupling region hse30. It may additionally be divided also along direction Y into a total of three regions, namely two coupling regions with a comparatively small area and one opposing region with a comparatively large area. In either case, one feature of heat distribution simulations according to the present invention is that a U-shape is divided into two opposing regions and one coupling region.

In the heat distribution simulations, CAE (computer-aided engineering) was used. The results of the heat distribution simulations were derived from, not only the size of the semiconductor chip SCH of the semiconductor device 10 and the size of the heat source element HSE, but also constant values, such as thermal conductivity coefficient [W/m•°C], density [kg/m³], and specific heat, of so-called component materials such as the leadframe on which the semiconductor device 10 was mounted, the die-bonding material, the wire, the sealing resin, etc.

In the heat distribution simulations according to the present invention, a silicon semiconductor chip SCH was used which had a size in the range, for example, from 1.0 mm × 1.0 to 1.4 mm × 1.4 mm. The heat source element HSE had an area that was 9% to 33% of the area of the entire semiconductor chip SCH.

In Figs. 5A to 5C, the opposing regions hse10 and hse20 had lengths x10 and x20 of, for example, 250 µm, and both had a length y0 of 350 µm. The coupling region hse30 had a length x30 of 110 µm, and was configured such that a distance (separation width) of 15 µm was left between the coupling region hse30 and the opposing regions hse10 and hse20, that the coupling region hse30 was separated from the opposing region hse10 and from the opposing region hse20, and that the opposing regions hse10 and hse20 were separated from each other.

Figs. 5A to 5C differ in lengths y1 and y2. In all of Figs. 5A to 5C, length y0, which is the sum of lengths y1 and y2, is constant.

In the heat distribution simulations according to the present invention, the electric power consumed in the heat source element HSE was so adjusted that the maximum temperature of the semiconductor chip SCH was 250°C. Specifically, the heat source element HSE was supplied with an electric power of 30 W. A maximum temperature of 250°C is not one that is tolerated in semiconductor devices of this type, but was simply for the sake of simulation. An electric power consumption of 30W, too, deviates from a normal use condition. Simulations performed under such a condition that greatly deviates from a normal use condition are considered to be useful to predict unexpected behavior and to estimate specific values of an actual heat distribution.

Fig. 5A schematically shows a configuration where lengths y1 and y2 were equal. With lengths y1 and y2 equal, the area of the space portion SP was approximately equal to that of the coupling region hse30. In this configuration, the temperature at points P1, which were the central portions of the opposing regions hse10 and hse20, and the temperature at point P2, which was the central portion of the coupling region hse30, were both 250°C, thus with no difference between the spots. The temperature at point P3, which was in the part of the coupling region hse30 opposite the temperature sensing element TE (unillustrated), was about 230°C, and the temperature at point P4, which was the central portion of the temperature sensing element TE, was about 200 °C. The temperature at point P5, which was located at an end of the space portion SP, was about 150°C. Thus, the temperature difference between points P1 and P2 with the highest temperature and point P5 was about 100°C, and the temperature difference between opposite ends of the space portion SP was about 80°C. This means that, when the thermal protection circuit TSD was arranged in the space portion SP, a temperature difference of approximately 80°C raised between elements arranged at points P3 and P5 in the space portion SP. A temperature difference of 80°C was one that arose when the temperature at points P1 and P2 reached 250°C. Assuming that the tolerated temperature at points P1 and P2 is, for example, 150°C, the temperature difference is surmised to be about 50°C instead of 80°C.

Fig. 5B schematically shows a configuration where, compared with Fig. 5A, the space portion SP was given a larger area and the coupling region hse30 was given an accordingly smaller area. Specifically, in this configuration, length y1 equaled two-thirds (67%) of length y0, and the length y2 of the coupling region hse30 was one-third (33%) of length y0. In this configuration, when the temperature at point P1 was 250°C, the temperature at point P2, which was the central portion of the coupling region hse30 was slightly lower, specifically about 240°C. The temperature at point P3 was about 220°C, and the temperature at point P4 was about 210°C. The temperature distribution at points P3 and 4 was largely the same as in Fig. 5A.

The reason that the temperature distribution at points P3 and P4 in Fig. 5B was largely the same as in Fig. 5A is surmised to be that, at those points, heat conduction from the opposing regions hse10 and hse20 and heat conduction from the coupling region hse30 jostled each other, with the opposing regions hse10 and hse20 having a stronger power to dominate than the coupling region hse30. The temperature at point P5 was about 140°C, largely the same as in Fig. 5A. The reason is surmised to be that, at point P5, which was far away both from the points P1, which were the central portions of the opposing regions hse10 and hse20, and from the point P2, which was the central portion of the coupling region hse30, the power to dominate heat conduction was weak.

Fig. 5C schematically shows a configuration where, compared with Fig. 5B, the space portion SP was given a still larger area and the heat source element HSE was given an accordingly smaller area. Specifically, length y1 was nine-tenths of length y0, and the length y2 of the coupling region hse30 was one-tenth of length y0. In this configuration, when the temperature at points P1 and P2 was 250°C, the temperature at points P2 and P3, which was the central portion of the coupling region hse30, was about 200°C. The temperature at point P4, which was the central portion Tc of the temperature sensing element TE, was about 190°C, and thus was about 20°C lower than in Fig. 5B. In any case, the temperature at the central portion Tc of the temperature sensing element TE was about 60°C different from the maximum temperature of 250°C, indicating lower temperature detection sensitivity than in Figs. 5A and 5B. The reasons for lower temperature detection sensitivity are surmised to be a smaller area (volume) of the coupling region hse30 resulting in weaker heat conduction to the temperature sensing element TE and a longer distance from the points P1, which are the central portions of the opposing regions hse10 and hse20, to the temperature sensing element TE.

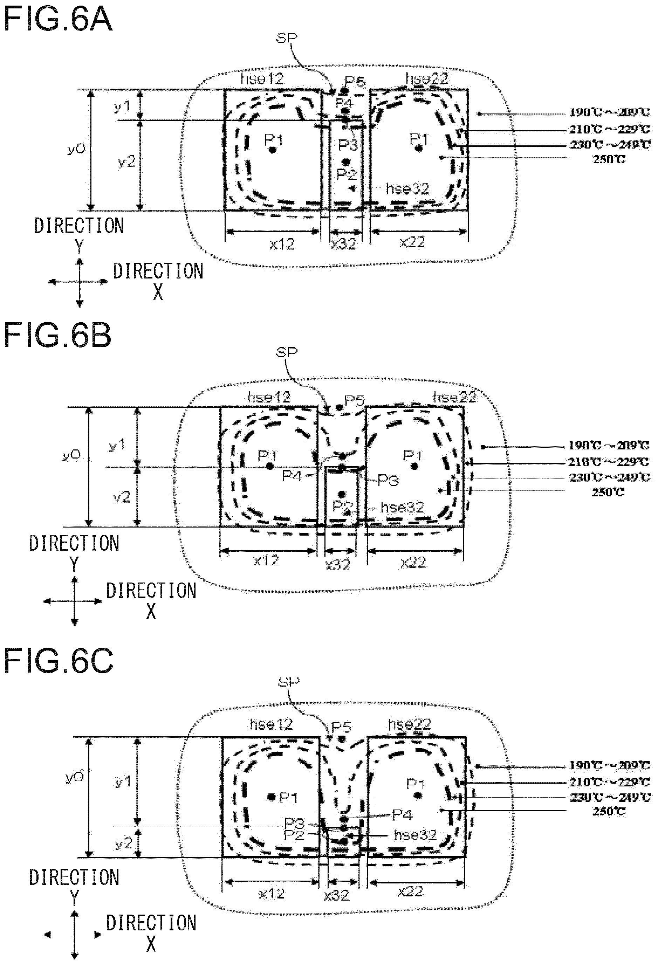

Like Figs. 5A to 5C, Figs. 6A to 6C show the results of heat distribution simulations with the U-shaped heat source element HSE shown in Figs. 1 to 4. The electric power that was applied to the entire heat source element HSE was assumed to be 30 W as in Figs. 5A to 5C.

In Figs. 6A to 6B, the lengths x12 and x22 of the opposing regions hse12 and hse22 both equaled 330 µm, length y0 equaled 350 µm, the length x32 of the coupling region hse32 equaled 110 µm, and a configuration was adopted where a distance of 15 µm was left between the coupling region hse32 and the opposing regions hse12 and hse22, the coupling region hse32 was separated from the opposing region hse12 and from the opposing region hse22, and the opposing regions hse12 and hse22 were separated from each other. Accordingly, in Figs. 6A to 6C, the lengths x12 and x22 of the opposing regions hse12 and hse22 equaled three times the length x32 of the coupling region hse32. This three-fold size differed from the approximately two-fold size shown in Figs. 5A to 5C.

Among Figs. 6A to 6C, lengths y1 and y2 differ. As in Figs. 5A to 5C, in all of Figs. 6A to 6C, length y0, which is the sum of lengths y1 and y2, is constant.

Fig. 6A shows a configuration where the space portion SP was given a comparatively small area. The ratio y1 / y0 of y1 to y0 equaled 0.25, and the ratio y2 / y0 of y2 to y0 equaled 0.75. With this configuration, heat distribution simulations with the heat source element HSE and the space portion SP revealed that, when the temperature at point P1 was highest, specifically 250°C, the temperature at point P2 also was 250°C. The temperature at point P3 then was about 240°C, and the temperature at point P4, which was the central portion Tc of the temperature sensing element TE, was about 220°C. The temperature at point P5 was about 210°C, and thus exhibited a temperature difference of about 40°C from the temperature at point P1, indicating a large difference from what is shown in Figs. 5A to 5C.

Fig. 6B shows a configuration where the space portion SP was given a still larger area than in Fig. 6(A). The ratio y1 / y0 of y1 to y0 equaled 0.5, and the ratio y2 / y0 of y2 to y0 equaled 0.5. With this configuration, heat distribution simulations with the heat source element HSE and the space portion SP revealed that, when the temperature at point P1 was highest, specifically 250°C, the temperature at point P2 also was 250°C. The temperature at point P3 then was about 240°C, and the temperature at point P4 was about 230°C. Thus, the temperature at point P4, which was the central portion Tc of the temperature sensing element TE, was about 20°C lower than the temperature at point P1. The temperature at point P5 was about 200°C.

In the configuration in Fig. 6B, the area of the space portion SP and the area of the coupling region hse32 are set approximately equal. Then, the distance from point P1 to point P4, that is, the distance from the central portions of the opposing regions hse12 and hse22 to the central portion (point P4) of the temperature sensing element TE is shortest. This shortest distance is shorter than that shown in Fig. 6A. Accordingly, the heat with the highest temperature is efficiently conducted to the temperature sensing element TE, and thus it is surmised that even part of the space portion SP is held at a high temperature.

Fig. 6C shows a configuration where the area of the space portion SP was still larger than in Fig. 6B. The ratio y1 / y0 of y1 to y0 equaled 0.75, and the ratio y2 / y0 of length y2 to length y0 equaled 0.25. With this configuration, heat distribution simulations with the heat source element HSE and the space portion SP revealed that, when the temperature at point P1 was highest, specifically 250°C, the temperature at point P2 was about 240°C. Then the temperature at points P3 and P4 was about 230°C. That is, the temperature at point P4, which was the central portion Tc of the temperature sensing element TE, exhibited a temperature difference of about 20°C from the highest temperature. Thus, as compared with Fig. 6C, the temperature difference between the highest temperature of the heat source element HSE and the temperature detected by the temperature sensing element TE was approximately the same.

In the structures of the heat source element HSE shown in Figs. 6A to 6C, as in those shown in Figs. 5A to 5C, the heat source element HSE is divided into three parts, namely two opposing regions and one coupling region. Simulations may also be performed with a heat source element HSE having a division structure different from those shown in Figs. 6A to 6C, for example with a structure like the one shown in Fig. 2 where the third side 13 is extended up to the sixth and seventh sides 16 and 17 to achieve division into three parts, namely two opposing regions and one coupling region. Also with such a configuration, the two opposing regions are arranged on opposite sides of the space portion SP, and the coupling region is formed so as to couple together the two opposing regions.

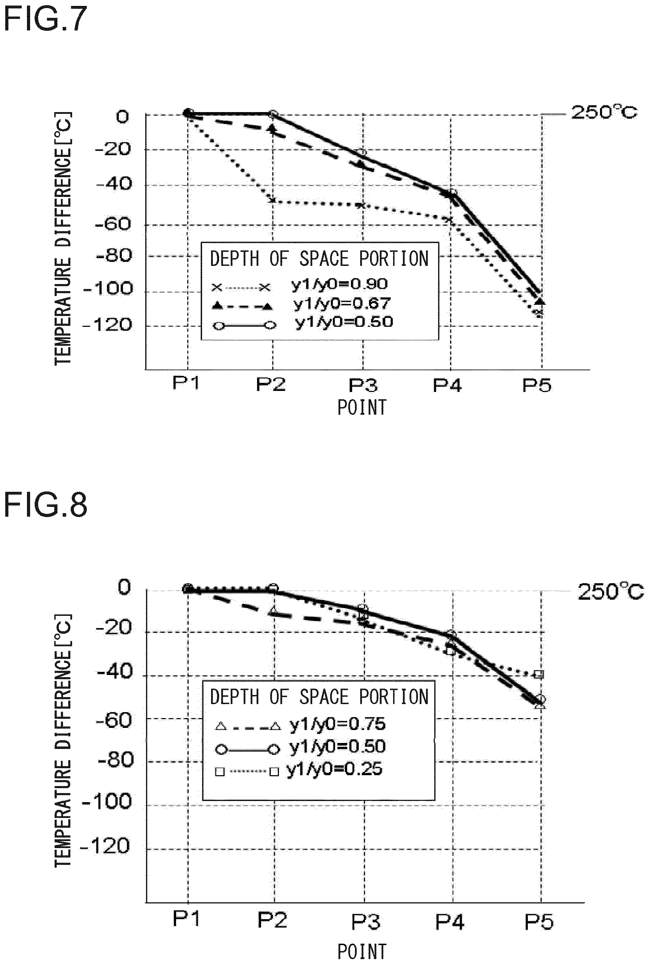

Fig. 7 is a temperature gradient diagram showing the results of the heat distribution simulations shown in Fig. 5 from a different perspective. In Fig. 7, along the horizontal axis are taken points P1 to P5, and along the vertical axis is taken the temperature difference from the highest temperature, that is, the temperature at point P1. As a parameter of a heat distribution, the depth of the space portion SP, that is, the ratio y1 / y0, is taken, and three values, namely y1 / y0 = 0.90, y1 / y0 = 0.67, and y1 / y0 = 0.50, are adopted.

In Fig. 7, point P1 indicates the central portions of the opposing regions hse10 and hse20 The temperature at point P1 was found to be about 250°C irrespective of the value of the parameter.

Point P2 corresponds to the central portion of the coupling region hse30. The temperature at point P2 differed slightly from that at point P1 : it exhibited the smallest temperature difference when the ratio y1 / y0 equaled 0.5, the temperature difference then being 0°C, and was then equal to the temperature at point P1; it exhibited the largest temperature difference when ratio y1 / y0 equaled 0.9, that is, when the space portion SP was given the largest area and the coupling region hse30 was given the smallest area throughout the simulations. The temperature at point P2 then was about 50°C lower than that at point P1.

Point P3 corresponds to a part of one side of the coupling region hse30; that is, it is the spot that corresponds to the end of the depth of the space portion SP and that is surmised to have the highest temperature in the space portion SP. Like point 2, point 3 exhibited the smallest temperature difference when the ratio y1 / y0 equaled 0.5, the temperature difference then being about 20°C; it exhibited the second smallest temperature difference when the ratio y1 / y0 was 0.67; it exhibited the largest temperature difference when the ratio y1 / y0 equaled 0.9, the temperature difference then being about 50°C.

Point P4 corresponds to the central portion Tc of the temperature sensing element TE. Point P4 was 30 µm to 60 µm away from point P3, and had a temperature that was about 20°C lower than that at point P3. However, no large temperature difference was observed between when the ratio y1 / y0 equaled 0.5 and when the ratio y1 / y0 equaled 0.67. However, compared with the temperatures observed at those times, a temperature difference of about 20°C was observed when the ratio y1 / y0 equaled 0.9. However, the temperature difference at point P4 was reduced compared with that at point P3.

Point P5 corresponds to a so-called entrance of the space portion SP, and is surmised to be the spot where the temperature is lowest in the space portion. Despite that, the simulation results revealed a temperature difference of about 110°C when the ratio y1 / y0 was in the range from 0.5 to 0.9. However, the temperature difference at point P5 was reduced compared with that at point P2. Incidentally, the characteristics shown in Fig. 7 can be interpreted as indicating that no large temperature difference was observed among the temperatures at different points when the ratio y1 / y0 was in the range firm 0.67 to 0.5. While no simulations were performed with the ratio y1 / y0 less than 0.5, it is surmised that characteristics similar to those observed when ratio y1 / y0 equaled 0.67 will be observed.

Fig. 8 is a temperature gradient diagram showing the results of the heat distribution simulations shown in Figs. 6A to 6C from a different perspective. In Fig. 8, along the horizontal axis are taken points P1 to P5, and along the vertical axis is taken the temperature difference from the highest temperature, that is, the temperature at point P1. As a parameter of a heat distribution, the depth of the space portion SP, that is, the ratio y1 / y0, is taken, and three values, namely y1 / y0 = 0.75, y1 / y0 = 0.50, y1 / y0 = 0.25, are adopted.

In Fig. 8, point P1 indicates the central portions of the opposing regions hse12 and hse22. The temperature at point P1 was about 250°C irrespective of the value of the parameter. Compared with the characteristics shown in Fig. 7, those shown in Fig. 8 exhibit smaller temperature differences, indicating that preferable results were obtained. It was also found that, as the depth of the space portion SP was varied, the temperatures at different points varied with approximately the same tendency as in Fig. 7. Specifically, the temperature difference was smallest when the ratio y1 / y0 equaled 0.5, and when the ratio was higher or lower, the temperature differences between point P1 and the other points tended to increase. However, compared with Fig. 7, the temperature differences at different points were smaller in Fig. 8, the absolute value of each temperature difference being reduced to approximately one-half.

Point P2 corresponds to the central portion of the coupling region hse32. The temperature at point P2 remained substantially the same irrespective of the ratio y1 / y0, and approximately equaled the highest temperature, namely 250°C.

Point P3 corresponds to a part of one side of the coupling region hse32; that is, it is the spot that corresponds to the end of the depth of the space portion SP and that is surmised to have the highest temperature in the space portion SP. The temperature difference at point P3 remained substantially the same irrespective of the depth of the space portion SP, and was approximately 240°C.

Point P4 corresponds to the central portion Tc of the temperature sensing element TE. Point P4 was 30 µm to 60 µm away from point P3, and had a temperature that was about 10°C lower than that at point P3. However, a temperature difference of about 10°C was observed between when the ratio y1 / y0 equaled 0.5 and when the ratio y1 / y0 equaled 0.25 or 0.75, the temperature difference thus being approximately the same as that at point P3.

Point P5 corresponds to the entrance of the space portion SP, and is surmised to be the spot where the temperature is lowest in the space portion. Despite that, the simulation results revealed a temperature in the range of 0.25 ≤ y1 / y0 ≤ 0.75, about 50°C lower than the highest temperature. However, the temperature at point P5 exhibited a temperature difference that is one-half of that in Fig. 7, that is, a greatly reduced temperature difference from the temperature at point P1.

To summarize, Fig. 8 reveals the following: giving the opposing regions hse12 and hse22 an area (volume) larger than that of the coupling region hse32 results in a smaller temperature gradient in the space portion SP, which is preferable in arranging the temperature sensing element TE there.

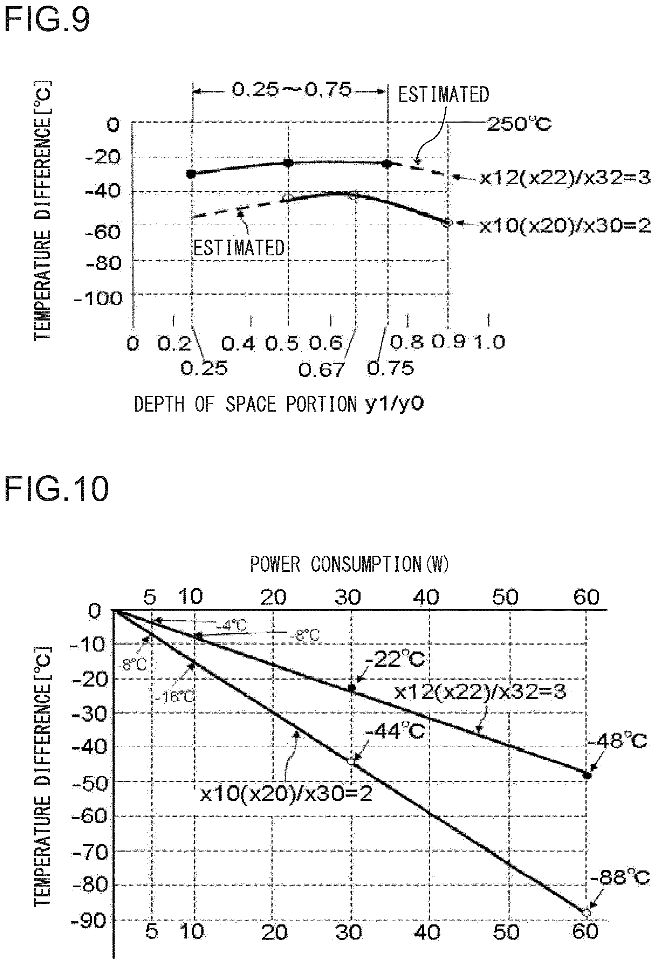

Fig. 9 is a temperature gradient diagram that plots the temperatures at point P4 shown in Figs. 7 to 8, in particular the temperature differences from the highest temperature of 250°C. It is needless to say that point P4 corresponds to the central portion Tc of the temperature sensing element TE and is a spot that is especially important for the monitoring of the temperature of the heat source element HSE. Specifically, it is possible to obtain increasingly high temperature detection sensitivity the closer the temperature at point P4 is to the temperature at point P1.

Fig. 9 gives two plots for different values as a parameter. One depicts a case where, as shown in Figs. 5A to 5C, the ratio of the length x10 (x20) to the length x30 of the coupling region hse30 in direction X, that is, x10 (x20) / x30, equaled 2; the other depicts a case where, as shown in Fig. 6, the ratio of the length x12 (x22) to the length x32 of the coupling region hse32 in direction X, that is, x12 (x22) / x32, equaled 3. In short, temperature detection sensitivity is compared between cases where the opposing regions were given a width that was twice and three times, respectively, that of the coupling region.

Fig. 9 reveals that giving the opposing regions a width larger than that of the coupling region results in a smaller temperature difference and higher temperature detection sensitivity. This tendency remained the same irrespective of the ratio (y1 / y0) that indicates the depth of the space portion SP. For example, when the ratio y1 / y0 equaled 0.5, the temperature difference was about 20°C with the triple width and about 40°C with the double width, the temperature difference approximately doubling between the two cases.

Fig. 9 also reveals that it is preferable that the ratio y1 / y0, which indicates the depth of the space portion SP, be close to a ratio y1 / y0 of 0.5, specifically in a range, for example, from 0.25 to 0.75.

Fig. 9 shows plots for cases where the opposing regions hse10 and hse20 or hse12 and hse22 were given a width that is twice or three times, respectively, the width of the coupling region hse30 or hse32. It is however surmised that the present invention will provide a similar effect not only with the double or triple width but even with an equal width, that is, even when the opposing regions have the same width as the coupling region. With reference back to Figs. 5A to 5C, as will be understood from Fig. 5C, heat conduction to the space portion SP is insufficient because of a long distance from the central portions (points P1) of the opposing regions hse10 and hse20. However, it is understood that increasing the area of the coupling region hse30 until it has a certain size as shown in Fig. 5A results in a rise in the temperature in the space portion SP. This state, seen from a different perspective, means that the coupling region hse30 is dominant in heat conduction to the space portion SP. In this state, the width of the coupling region hse30 is one-half of that of the opposing regions hse10 and hse20. This can be interpreted to indicate that giving the opposing regions hse10 and hse20 the same width as the coupling region hse30 will provide a similar effect.

In the semiconductor device 10 according to the present invention, the heat source element HSE is formed in a U-shape and, to provide the space portion SP with a predetermined size, is divided into three regions classified into two opposing regions and one coupling region. Thereafter, while predetermined consumption electric power is applied to the heat source element HSE and the highest temperature is monitored and controlled, simulations are performed as to the heat distribution and heat gradient in the heat source element HSE and the space portion SP. Thereafter, the results of the simulations are analyzed. In the analysis, the highest temperature of the heat source element HSE, the temperature difference in the temperature sensing element TE, and the heat distribution and heat gradient in the space portion SP are studied. Thereafter, based on the results of the analysis, the area required to arrange the thermal protection circuit TSD in the space portion SP is determined, and finally the shape and size of the heat source element HSE and the space portion SP are determined. Through these steps, the area required in the heat source element HSE and the semiconductor device 10 suitable for the thermal protection circuit TSD to accomplish its function can be designed.

Fig. 10 is a simulation diagram showing a relationship between electric power consumption and temperature detection sensitivity in the heat source element HSE. Specifically, it shows the results of heat distribution simulations that show the temperature difference between point P1 and point P4, which is the central portion Tc of the temperature sensing element TE, at varying electric power consumption. As a parameter, two values were adopted, namely a configuration where, as shown in Figs. 5A to 5C, the lateral widths x10 and x20 of the opposing regions hse10 and hse20 equaled twice the lateral width x30 of the coupling region hse30 and a configuration where, as shown in Figs. 6A to 6C, the lateral widths x12 and x22 of the opposing regions hse12 and hse22 equaled three times the lateral width x32 of the coupling region hse32. In both configurations, y1 / y0 equaled 0.5 and y2 / y0 equaled 0.5, and the space portion SP and the coupling region hse30 (hse32) had approximately the same size.

Figs. 5A to 5C, Figs. 6A to 6C, and Figs. 7 to 9 thus far referred to deal with cases where the electric power consumption in the heat source element HSE was 30 W. Fig. 10 is a characteristics diagram obtained from the results of heat distribution simulations when the electric power consumption was 30 W and 60 W. Along the horizontal axis is taken electric power consumption, and along the vertical axis is taken temperature difference.

With the double lateral width, that is, with x10 (x20) / x 30 = 2, when the electric power consumption was 30 W, the temperature difference between points P1 and P4 was 44°C. Increasing the electric power consumption to 60 W with the other conditions unchanged caused the temperature difference to rise up to 88°C.

On the other hand, with the triple lateral width, that is, with x12 (x22) / x 32 = 3, when the electric power consumption was 30 W, the temperature difference between points P1 and P4 was 22°C. Increasing the electric power consumption to 60 W with the other conditions unchanged caused the temperature difference to rise up to 48°C. However, it was found that, with the triple lateral width, the temperature difference between points P1 and P4 was far smaller than with the double lateral width. This suggests that, as a barometer that indicates the temperature detection sensitivity of the temperature sensing element TE, the ratio of the lateral width of the opposing regions (x10, x20, x12, x22) to that of the coupling region (hse30, hse32) matters greatly.

The results of heat distribution simulations shown in Fig. 10 are extremely useful in designing and manufacturing semiconductor devices and semiconductor integrated circuit devices of similar kinds. The reason is that the temperature detection sensitivity of the temperature sensing element TE for a wide range of electric power consumption by the heat source element HSE can be estimated.

From Fig. 10, it is possible to estimate, for example, the temperature detection sensitivity of the temperature sensing element TE as will be obtained when the electric power consumption of the heat source element HSE is 5 W. It is seen that, when the lateral width of the opposing regions is twice that of the coupling region, the temperature difference is about 8°C and, when the lateral width ratio is three times, the temperature difference is about 4°C. Thus, it is seen that, when the electric power consumption of the heat source element HSE is 5 W, the detection sensitivity of the temperature sensing element TE is 10°C or less. It is also seen that, when the electric power consumption is 10 W, the temperature difference is about 16°C and about 8°C respectively.

The characteristics diagram shown in Fig. 10 varies depending on the thermal conductivity coefficient [W/m•°C], density [kg/m³], specific heat, etc. of so-called component materials such as the leadframe on which the semiconductor device 10 is mounted, the die-bonding material, the wire, the resin, etc. Thus, by previously preparing several combinations, it is possible to reduce the design period, and enhance the product quality, of the semiconductor device 10.

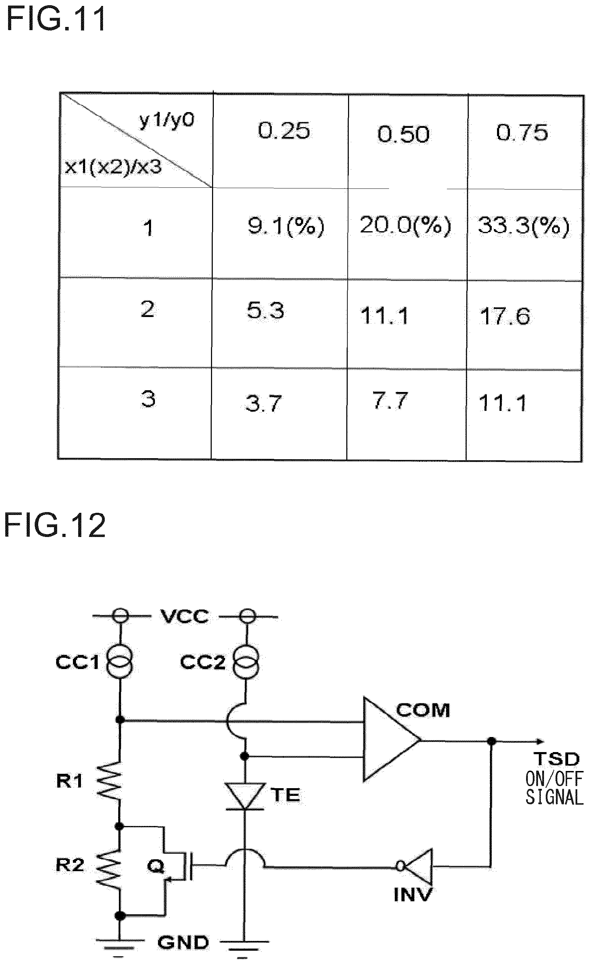

Fig. 11 shows an area ratio of the area of the heat source element HSE to that of the space portion SP, and is a diagram obtained by use, as parameters, of the entrance width (length x3) and depth (length y1) of the space portion SP and the widths (lengths x1 and x2) of the opposing regions hsel1 and hsel2.

In Fig. 11, for example, when x1 (x2) / x3 = 2 and y1 / y0 = 0.50, the area of the space portion SP equals one-ninth (= 0.11) of that of the heat source element HSE, and thus the area ratio is 11.1 %. This holds with Fig. 5A. When x1 (x2) / x3 = 3 and y1 / y0 = 0.50, the area of the space portion SP is one-thirteenth of that of the heat source element, and thus the area ratio is 7.7 %. This holds with Fig. 6B. Although not illustrated in any diagram so far, when x1 (x2) / x3 = 1 and y1 / y0 = 0.75, the area of the space portion SP equals one-third of that of the heat source element HSE, and thus the area ratio is 33.3%. In the present invention, the proportion of the area of the space portion SP that occupies the area of the heat source element HSE is usually in the range from 3.7% to 33.3% shown in Fig. 11. That is, let the areas of the heat source element HSE and the space portion SP as seen in a plan view be S1 and S2 respectively, then S2 falls largely in the range from 0.037 × S1 to 0.333 × S1.

Fig. 12 shows one example of a specific circuit configuration of the thermal protection circuit TSD arranged in the space portion SP. The thermal protection circuit TSD is of a well-known design. The thermal protection circuit TSD includes, in addition to the temperature sensing element TE, for example, constant current sources CC1 and CC2, resistors R1 and R2, a transistor Q, a comparator COM, and an inverter INV. As the temperature sensing element TE, for example, a diode-connected transistor is used. When the temperature sensing element TE is, for example, a diode, the forward voltage across the diode has a temperature coefficient of, for example, -2 mV with respect to variation in temperature. Thus, by subjecting the voltage occurring in the temperature sensing element TE to comparison by the comparator COM, it is possible to detect the temperature of the heat source element HSE. According to a TSD ON/OFF signal output from the comparator COM, the thermal protection circuit TSD is turned ON and OFF. As the temperature sensing element TE, a diffusion resistor, polysilicon resistor, or the like formed of a semiconductor can also be used. The thermal protection circuit TSD shown in Fig. 12 is merely one example; its circuit configuration may be more complicate, with a higher degree of integration, or may be simpler. The entrance width and depth of the space portion SP can be determined according to the circuit configuration and the number of circuit components.

### Industrial Applicability

With a semiconductor device and a method for designing one according to the present invention, it is possible, with a temperature sensing element, to detect a temperature that is close to the temperature of a heat source element based on heat distribution simulations. Thus, the present invention has extremely high industrial applicability, being suitable for use in semiconductor devices including power transistors, and for monitoring and controlling heat in semiconductor integrated circuit devices.

### List of Reference Signs

- 10: semiconductor device
- 11: first side
- 12: second side
- 13: third side
- 14: fourth side
- 15: fifth side
- 16: sixth side
- 17: seventh side
- 18: eighth side
- CC1, CC2: constant current source
- COM: comparator
- HSE: heat source element
- hse1, hse2, hse10, hse12, hse20, hse22: opposing region
- hse3, hse30, hse32: coupling region
- OC: other circuits
- P1 to P5: point
- Q: transistor
- SCH: semiconductor chip
- SP: space portion
- TE: temperature sensing element
- TSD: thermal protection circuit

## Claims

1. A semiconductor device (10) having a heat source element (HSE) and a temperature sensing element (TE), wherein,
as seen in a plan view, the heat source element has a shape defined by:
1.1 a first side (11) that has a first distance x1;
1.2 a second side (12) that is located on a same line as, but a second distance x3 away from, the first side and that extends over a third distance x2 in a direction away from the first side;
1.3 a third side (13) that is located a fourth distance y1 away from, in a direction perpendicular to, the first and second sides and that has a same length as the second distance x3;
1.4 a fourth side (14) that connects together one end of the first side and one end of the third side;
1.5 a fifth side (15) that connects together one end of the second side and another end of the third side;
1.6 a sixth side (16) of which one end is connected to another end of the first side and that extends in a same direction as, and has a larger length than, the fourth side, said length being expressed as a length y0;
1.7 a seventh side (17) that is connected to another end of the second side and of which one end extends in a same direction as, and has a larger length than, the fifth side, said length being expressed as the length y0; and
1.8 an eighth side (18) that connects together another end of the sixth side and another end of the seventh side, the eighth side having a length x0,
1.9 the temperature sensing element (TE) is arranged near the third side 13); and
1.10 a central portion (TC) of the temperature sensing element is arranged nearer to the third side than to the fourth and fifth sides.

2. The semiconductor device of claim 1, wherein
between the fourth distance y1 and the length y0, a relationship 0.25 ≤ y1 / y0 ≤ 0.75 holds.

3. The semiconductor device of claim 2, wherein
the fourth distance y1 substantially fulfills a relationship y1 / y0 = 0.5.

4. The semiconductor device of claim 2, wherein
the first and second distances x1 and x2 substantially fulfill a relationship x3 ≤ x1 = x2 ≤ 3 × x3.

5. The semiconductor device of any one of claims 1 to 4, wherein
the heat source element and the temperature sensing element are arranged in a space portion (SP) demarcated by the first, second, third, fourth, and fifth sides, and
when, as seen in a plan view, an area of the heat source element is represented by S1 and an area of the space portion is represented by S2, a relationship 0.037 × S1 ≤ S2 ≤ 0.333 × S1 holds.

6. The semiconductor device of claim 5, wherein
the temperature sensing element forms part of a thermal protection circuit (TPD),
the thermal protection circuit includes:
a constant current source (CC1, CC2) that supplies a constant current to the temperature sensing element and a reference voltage circuit; and
a comparator (COM) that compares together a reference voltage from the reference voltage circuit and a voltage occurring in the temperature sensing element, and
the thermal protection circuit is arranged in the space portion.

7. A semiconductor device having a heat source element (HSE) and a temperature sensing element (TE) in a semiconductor chip (SCH), wherein
7.1 the heat source element has a U-shape composed of two opposing regions (hse1, hse2, hse10, hse12, hse20, hse22) that are located on opposite sides of a space portion (SP) and a coupling region (hes3, hse30, hse32) that couples together the two opposing regions,
7.2 the temperature sensing element is arranged in the space portion near the coupling region; and
7.3 a distance between a central portion of the temperature sensing element and a central portion of the coupling region is shorter than a distance between the central portion of the temperature sensing element and a central portion of one of the opposing regions.

8. A method for designing the semiconductor device of claim 7, the method comprising:
a first step of dividing the U-shaped heat source element into three regions and determining sizes and shapes of the divided regions and of the space portion;
a second step of performing a heat distribution simulation with respect to the heat source element and the space portion determined in the first step;
a third step of analyzing simulation results performed in the second step; and
a fourth step of determining the sizes of the three regions and of the space portion based on simulation results obtained in the third step.

9. A method for designing the semiconductor device of claim 1, the device having a heat source
element (HSE) and a temperature sensing element (TE), the heat source element (HSE) having a U-shape composed of two opposing regions (hse1, hse2, hse10, hse12, hse20, hse22) that are located on opposite sides of a space portion (SP) and a coupling region (hes3, hse30, hse32) that couples together the two opposing regions, the temperature sensing element being arranged in the space portion near the coupling region, and the method comprising:
9.1 a first step of dividing the U-shaped heat source element into three regions and determining sizes and shapes of the divided regions and of the space portion;
9.2 a second step of performing a heat distribution simulation with respect to the heat source element and the space portion determined in the first step;
9.3 a third step of analyzing simulation results performed in the second step; and
9.4 a fourth step of determining the sizes of the three regions and of the space portion based on simulation results obtained in the third step.

10. The method of claim 8 or 9, wherein
two of the three regions are the opposing regions and one of the three regions is the coupling region.

## Patentansprüche

1. Halbleitervorrichtung (10) mit einem Wärmequellenelement (HSE) und einem Temperaturerfassungselement (TE), wobei,
bei Betrachtung in einer Draufsicht, das Wärmequellenelement eine Form aufweist, die durch Folgendes definiert ist:
1.1 eine erste Seite (11), die einen ersten Abstand x1 hat,
1.2 eine zweite Seite (12), die sich auf einer gleichen Linie wie die erste Seite, aber in einem zweiten Abstand x3 weg davon, befindet und die sich über einen dritten Abstand x2 in eine Richtung weg von der ersten Seite erstreckt,
1.3 eine dritte Seite (13), die sich in einem vierten Abstand y1 weg von, in eine Richtung senkrecht zu, der ersten und zweiten Seite befindet und die eine gleiche Länge hat wie der zweite Abstand x3,
1.4 eine vierte Seite (14), die ein Ende der ersten Seite und ein Ende der dritten Seite miteinander verbindet,
1.5 eine fünfte Seite (15), die ein Ende der zweiten Seite und ein anderes Ende der dritten Seite miteinander verbindet,
1.6 eine sechste Seite (16), von der ein Ende mit einem anderen Ende der ersten Seite verbunden ist und die sich in eine gleiche Richtung erstreckt wie, und eine größere Länge aufweist als, die vierte Seite, wobei die Länge als eine Länge y0 ausgedrückt wird,
1.7 eine siebte Seite (17), die mit einem anderen Ende der zweiten Seite verbunden ist und von der sich ein Ende in eine gleiche Richtung erstreckt wie, und eine größere Länge aufweist als, die fünfte Seite, wobei die Länge als die Länge y0 ausgedrückt wird, und
1.8 eine achte Seite (18), die ein anderes Ende der sechsten Seite und ein anderes Ende der siebten Seite miteinander verbindet, wobei die achte Seite eine Länge x0 aufweist,
1.9 wobei das Temperaturerfassungselement (TE) nahe der dritten Seite (13) angeordnet ist und
1.10 ein zentraler Abschnitt (TC) des Temperaturerfassungselements näher zu der dritten Seite angeordnet ist als zu der vierten und fünften Seite.

2. Halbleitervorrichtung nach Anspruch 1, wobei für eine Beziehung zwischen dem vierten Abstand y1 und der Länge y0 0,25 ≤ y1 / y0 ≤ 0,75 gilt.

3. Halbleitervorrichtung nach Anspruch 2, wobei der vierte Abstand y1 eine Beziehung von y1 / y0 = 0,5 im Wesentlichen erfüllt.

4. Halbleitervorrichtung nach Anspruch 2, wobei der erste und zweite Abstand x1 und x2 eine Beziehung von x3 ≤ x1 = x2 ≤ 3 × x3 im Wesentlichen erfüllen.

5. Halbleitervorrichtung nach einem der Ansprüche 1 bis 4, wobei
das Wärmequellenelement und das Temperaturerfassungselement in einem Raumabschnitt (SP) angeordnet sind, der durch die erste, zweite, dritte, vierte und fünfte Seite abgegrenzt ist, und
wenn, bei Betrachtung in einer Draufsicht, ein Bereich des Wärmequellenelements durch S1 dargestellt ist und ein Bereich des Raumabschnitts durch S2 dargestellt ist, für eine Beziehung 0,037 × S1 ≤ S2 ≤ 0,333 × S1 gilt.

6. Halbleitervorrichtung nach Anspruch 5, wobei das Temperaturerfassungselement einen Teil einer thermischen Schutzschaltung (TPD) bildet,
die thermische Schutzschaltung Folgendes aufweist:
eine konstante Stromquelle (CC1, CC2), die dem Temperaturerfassungselement und einer Referenzspannungsschaltung einen konstanten Strom zuführt, und
einen Vergleicher (COM), der eine Referenzspannung von der Referenzspannungsschaltung und eine Spannung, die in dem Temperaturerfassungselement auftritt, miteinander vergleicht, und
die thermische Schutzschaltung in dem Raumabschnitt angeordnet ist.

7. Halbleitervorrichtung mit einem Wärmequellenelement (HSE) und einem Temperaturerfassungselement (TE) in einem Halbleiterchip (SCH), wobei
7.1 das Wärmequellenelement eine U-Form aufweist, die aus zwei gegenüberliegenden Bereichen (hse1, hse2, hse10, hse12, hse20, hse22), die sich auf gegenüberliegenden Seiten eines Raumabschnitts (SP) befinden, und einem Kopplungsbereich (hes3, hse30, hse32), der die zwei gegenüberliegenden Bereiche miteinander koppelt, besteht,
7.2 das Temperaturerfassungselement in dem Raumabschnitt nahe dem Kopplungsbereich angeordnet ist und
7.3 ein Abstand zwischen einem zentralen Abschnitt des Temperaturerfassungselements und einem zentralen Abschnitt des Kopplungsbereichs kürzer ist als ein Abstand zwischen dem zentralen Abschnitt des Temperaturerfassungselements und einem zentralen Abschnitt eines der gegenüberliegenden Bereiche.

8. Verfahren zum Auslegen der Halbleitervorrichtung nach Anspruch 7, wobei das Verfahren Folgendes umfasst:
einen ersten Schritt zum Unterteilen des U-förmigen Wärmequellenelements in drei Bereiche und Bestimmen von Größen und Formen der unterteilten Bereiche und des Raumabschnitts,
einen zweiten Schritt zum Durchführen einer Wärmeverteilungssimulation in Bezug auf das Wärmequellenelement und den Raumabschnitt, die in dem ersten Schritt bestimmt werden,
einen dritten Schritt zum Analysieren von Simulationsergebnissen, der in dem zweiten Schritt durchgeführt wird, und
einen vierten Schritt zum Bestimmen der Größen der drei Bereiche und des Raumabschnitts basierend auf Simulationsergebnissen, die in dem dritten Schritt erhalten werden.

9. Verfahren zum Auslegen der Halbleitervorrichtung nach Anspruch 1, wobei die Vorrichtung ein Wärmequellenelement (HSE) und ein Temperaturerfassungselement (TE) hat, wobei das Wärmequellenelement (HSE) eine U-Form aufweist, die aus zwei gegenüberliegenden Bereichen (hse1, hse2, hse10, hse12, hse20, hse22), die sich auf gegenüberliegenden Seiten eines Raumabschnitts (SP) befinden, und einem Kopplungsbereich (hes3, hse30, hse32), der die zwei gegenüberliegenden Bereiche miteinander koppelt, besteht, wobei das Temperaturerfassungselement in dem Raumabschnitt nahe dem Kopplungsbereich angeordnet ist und das Verfahren Folgendes umfasst:
9.1 einen ersten Schritt zum Unterteilen des U-förmigen Wärmequellenelements in drei Bereiche und Bestimmen von Größen und Formen der unterteilten Bereiche und des Raumabschnitts,
9.2 einen zweiten Schritt zum Durchführen einer Wärmeverteilungssimulation in Bezug auf das Wärmequellenelement und den Raumabschnitt, die in dem ersten Schritt bestimmt werden,
9.3 einen dritten Schritt zum Analysieren von Simulationsergebnissen, der in dem zweiten Schritt durchgeführt wird, und
9.4 einen vierten Schritt zum Bestimmen der Größen der drei Bereiche und des Raumabschnitts basierend auf Simulationsergebnissen, die in dem dritten Schritt erhalten werden.

10. Verfahren nach Anspruch 8 oder 9, wobei
zwei der drei Bereiche die gegenüberliegenden Bereiche sind und einer der drei Bereiche der Kopplungsbereich ist.

## Revendications

1. Dispositif à semi-conducteur (10) ayant un élément de source de chaleur (HSE) et un élément de détection de température (TE), dans lequel,
dans une vue en plan, l'élément de source de chaleur a une forme définie par :
1.1 un premier côté (11) qui a une première distance x1 ;
1.2 un deuxième côté (12) qui est situé sur une même ligne que le premier côté mais éloigné d'une deuxième distance x3 de celui-ci et qui s'étend sur une troisième distance x2 dans une direction éloignée du premier côté ;
1.3 un troisième côté (13) qui est situé éloigné d'une quatrième distance y1 des premier et deuxième côtés, dans une direction perpendiculaire à ceux-ci, et qui a une même longueur que la deuxième distance x3 ;
1.4 un quatrième côté (14) qui relie conjointement une extrémité du premier côté et une extrémité du troisième côté ;
1.5 un cinquième côté (15) qui relie conjointement une extrémité du deuxième côté et une autre extrémité du troisième côté ;
1.6 un sixième côté (16) dont une extrémité est reliée à une autre extrémité du premier côté et qui s'étend dans une même direction que le quatrième côté, et a une longueur plus grande que celui-ci, ladite longueur étant exprimée en tant que longueur y0 ;
1.7 un septième côté (17) qui est relié à une autre extrémité du deuxième côté et dont une extrémité s'étend dans une même direction que le cinquième côté, et a une longueur plus grande que celui-ci, ladite longueur étant exprimée en tant que longueur y0 ; et
1.8 un huitième côté (18) qui relie conjointement une autre extrémité du sixième côté et une autre extrémité du septième côté, le huitième côté ayant une longueur x0,
1.9 l'élément de détection de température (TE) est agencé près du troisième côté (13) ; et
1.10 une portion centrale (TC) de l'élément de détection de température est agencée plus près du troisième côté que des quatrième et cinquième côtés.

2. Dispositif à semi-conducteur selon la revendication 1, dans lequel
entre la quatrième distance y1 et la longueur y0, une relation 0,25 ≤ y1/y0 ≤ 0,75 est vérifiée.

3. Dispositif à semi-conducteur selon la revendication 2, dans lequel
la quatrième distance y1 satisfait sensiblement une relation y1/y0 = 0,5.

4. Dispositif à semi-conducteur selon la revendication 2, dans lequel
les première et deuxième distances x1 et x2 satisfont sensiblement une relation x3 ≤ x1 = x2 ≤ 3 x x3.

5. Dispositif à semi-conducteur selon l'une quelconque des revendications 1 à 4, dans lequel
l'élément de source de chaleur et l'élément de détection de température sont agencés dans une portion d'espace (SP) délimitée par les premier, deuxième, troisième, quatrième et cinquième côtés, et
lorsque, dans une vue en plan, une aire de l'élément de source de chaleur est représentée par S1 et une aire de la portion d'espace est représentée par S2, une relation 0,037 x S1 ≤ S2 ≤ 0,333 x S1 est vérifiée.

6. Dispositif à semi-conducteur selon la revendication 5, dans lequel
l'élément de détection de température fait partie d'un circuit de protection thermique (TPD),
le circuit de protection thermique comporte :
une source de courant constant (CC1, CC2) qui fournit un courant constant à l'élément de détection de température et un circuit de tension de référence ; et
un comparateur (COM) qui compare une tension de référence du circuit de tension de référence et une tension se trouvant dans l'élément de détection de température, et
le circuit de protection thermique est agencé dans la portion d'espace.

7. Dispositif à semi-conducteur ayant un élément de source de chaleur (HSE) et un élément de détection de température (TE) dans une puce de semi-conducteur (SCH), dans lequel
7.1 l'élément de source de chaleur a une forme en U composée de deux régions opposées (hse1, hse2, hse10, hse12, hse20, hse22) qui sont situées sur des côtés opposés d'une portion d'espace (SP) et une portion d'accouplement (hes3, hse30, hse32) qui accouple conjointement les deux régions opposées,
7.2 l'élément de détection de température est agencé dans la portion d'espace près de la région d'accouplement; et
7.3 une distance entre une portion centrale de l'élément de détection de température et une portion centrale de la région d'accouplement est plus courte qu'une distance entre la portion centrale de l'élément de détection de température et une portion centrale de l'une des régions opposées.

8. Procédé de conception du dispositif à semi-conducteur selon la revendication 7, le procédé comprenant :
une première étape de division de l'élément de source de chaleur en forme de U en trois régions et de détermination de tailles et de formes des régions divisées et de la portion d'espace ;
une deuxième étape de réalisation d'une simulation de distribution de chaleur par rapport à l'élément de source de chaleur et la portion d'espace déterminée à la première étape ;
une troisième étape d'analyse de résultats de simulation réalisés à la deuxième étape ; et
une quatrième étape de détermination des tailles des trois régions et de la portion d'espace d'après des résultats de simulation obtenus à la troisième étape.

9. Procédé de conception du dispositif à semi-conducteur selon la revendication 1, le dispositif ayant un élément de source de chaleur (HSE) et un élément de détection de température (TE), l'élément de source de chaleur (HSE) ayant une forme de U composée de deux régions opposées (hse1, hse2, hse10, hse12, hse20, hse22) qui sont situées sur des côtés opposés d'une portion d'espace (SP) et une portion d'accouplement (hes3, hse30, hse32) qui accouple conjointement les deux régions opposées, 1 élément de détection de température étant agencé dans la portion d'espace près de la région d'accouplement, et le procédé comprenant :
9.1 une première étape de division de l'élément de source de chaleur en forme de U en trois régions et de détermination de tailles et de formes des régions divisées et de la portion d'espace ;
9.2 une deuxième étape de réalisation d'une simulation de distribution de chaleur par rapport à l'élément de source de chaleur et la portion d'espace déterminée à la première étape ;
9.3 une troisième étape d'analyse de résultats de simulation réalisés à la deuxième étape ; et
9.4 une quatrième étape de détermination des tailles des trois régions et de la portion d'espace d'après des résultats de simulation obtenus à la troisième étape.

10. Procédé selon la revendication 8 ou 9, dans lequel deux des trois régions sont les régions opposées et l'une des trois régions est la région d'accouplement.
